# EUROPÄISCHE PATENTANMELDUNG

(11) **EP 1 608 059 A1**
(43) Veröffentlichungstag der Anmeldung: **21.12.2005**
(21) Anmeldenummer: 05008459.9
(22) Anmeldetag: 19.04.2005
(51) Int. Cl.: H03B 5/12

(54) **Oszillator und Verfahren zur Einstellung der Frequenz eines Oszillators**

(30) Priorität: 22.04.2004 DE 102004020975
(71) Anmelder: ATMEL Germany GmbH, 74072 Heilbronn (DE)
(72) Erfinder: Reimann, Reinhard Dr-.Ing, 74081 Heilbronn (DE)

(57) **Zusammenfassung**

Vorgestellt wird ein Oszillator (100) mit einem Schwingkreis (102) aus wenigstens einer Schwingkreis-Induktivität (18, 20) und einer ersten Schwingkreis-Kapazität (108), wobei der Wert der ersten Schwingkreis-Kapazität (108) durch erste Steuerspannungen zwischen verschiedenen Stufen umsteuerbar ist. Der Oszillator (100) zeichnet sich durch eine erste Steuerspannungsquelle (116, 118, 120, 122) aus, die erste Steuerspannungen mit wenigstens drei stufenförmig unterschiedlichen Werten an die erste Schwingkreis-Kapazität (108) anlegt. Bevorzugt werden die Steuerspannungen über ein Netzwerk von Stromquellen und Widerständen erzeugt, wobei das Netzwerk den Temperaturgang des Oszillators (100) kompensiert. Ferner wird ein Verfahren zum Betreiben eines solchen Oszillators vorgestellt.

## Beschreibung

Die Erfindung betrifft einen Oszillator mit einem Schwingkreis aus wenigstens einer Schwingkreis-Induktivität und einer ersten Schwingkreis-Kapazität, wobei der Wert der ersten Schwingkreis-Kapazität durch erste Steuerspannungen zwischen verschiedenen Stufen umsteuerbar ist.

Ferner betrifft die Erfindung ein Verfahren zur Einstellung der Frequenz eines Oszillators mit einem Schwingkreis aus wenigstens einer Schwingkreis-Induktivität und einer ersten Schwingkreis-Kapazität, wobei der Wert der ersten Schwingkreis-Kapazität durch erste Steuerspannungen zwischen verschiedenen Stufen umgesteuert wird.

Ein solcher Oszillator und ein solches Verfahren sind per se bekannt. Zusätzlich zu diesem Stand der Technik ist aus dem Artikel "A Fully Integrated SiGe Bipolar 2.4 GHz Bluetooth Voltage Controlled Oscillator", 2000 IEEE Radio Frequency Integrated Circuits Symposium, ein Oszillator bekannt, dessen Frequenz durch eine analoge Abstimmspannung in Verbindung mit einem Paar von Varaktordioden gesteuert wird.

Solche Schwingkreise werden zum Beispiel bei spannungsgesteuerten Oszillatoren und in Phasenregelschleifen eingesetzt, um ein Signal definierter Frequenz zu erzeugen. Sie weisen meist einen Resonator (Schwingkreis) aus einer Parallelschaltung aus induktiven und kapazitiven Bauelementen auf. In einem solchen Schwingkreis können bei der Resonanzfrequenz hohe Ströme zwischen der Induktivität und der Kapazität hin und her schwingen, wobei in den Zuleitungen nur kleine Ströme fließen. Dämpfungsverluste werden durch eine äußere Beschaltung kompensiert, die dem Schwingkreis im Idealfall phasenrichtig abgestrahlte und/oder Joule'sche Verlustenergie wieder zuführt.

Anstelle einer Forderung nach einer scharf definierten, festen Resonanzfrequenz ist bei technischen Anwendungen in der Regel eine gewisse Bandbreite gefordert, innerhalb der die Resonanzfrequenz des Schwingkreises gesteuert einstellbar sein soll. Bei Bluetooth-Anwendungen (Radio-Kommunikation über kurze Reichweiten in der Größenordnung einiger Meter) ist dies zum Beispiel eine Bandbreite von 0,1 GHz zwischen 2,4 und 2,5 GHz. Die Einstellung der gewünschten Frequenz erfolgt in der Regel durch eine gesteuerte Veränderung der Schwingkreiskapazität. Diese Schwingkreiskapazität wird meist durch Kapazitätsdioden realisiert, die eine von einer Steuerspannung abhängige Kapazität aufweisen.

Neben dieser erwünschten Abhängigkeit, die zur Steuerung ausgenutzt wird, treten auch unerwünschte Abhängigkeiten auf, die zum Beispiel durch fertigungsbedingte Schwankungen von Bauteileigenschaften und durch schwankende Betriebstemperaturen bedingt sind. Aus diesem Grund muss der Einstellbereich der Steuerung auch den durch Temperaturdriften und Fertigungstoleranzen auftretenden Frequenzversatz abdecken. Dabei wird der Einstellbereich der Steuerung durch die Eigenschaften der verwendeten Bauteile, zum Beispiel durch die mögliche Kapazitätsvariation von Kapazitätsdioden und durch die Schaltungseigenschaften, insbesondere durch den maximalen Bereich möglicher Steuerspannungen bestimmt. In der mobilen Kommunikationstechnik sind zum Beispiel Versorgungsspannungen zwischen 3 V und 3,6 V üblich, was die mögliche Kapazitätsvariation erheblich einschränkt.

Bei dem per se bekannten Oszillator ist die gesamte Schwingkreiskapazität in parallel liegende, schaltbare Schwingkreiskapazitäten und eine über eine analoge Steuerspannung V_tune veränderliche Kapazität aufgeteilt. Die parallel liegenden, schaltbaren Einzelkapazitäten werden gesteuert in den Schwingkreis eingeschaltet oder aus dem Schwingkreis herausgeschaltet. Diese Lösung hat den Nachteil eines hohen Platzbedarfs, da dieser mit der Zahl der zu schaltenden Kapazitäten ansteigt. Außerdem löst die bekannte Schaltung das Problem der Temperaturabhängigkeit nicht oder zumindest nur unzureichend. Das Phasenrauschen ist immer dann vergrößert, wenn der mittels V_tune gewählte abzustimmende Frequenzbereich größer ist, als dies der reine Abstimmbereich erfordert. Dies ist der Fall wenn entweder alle Kapazitäten mit Vtune analog angesteuert werden oder die mit V_tune angesteuerten Kapazitäten neben dem eigentlichen Abstimmbereich auch durch Fertigungstoleranzen bedingte und/oder durch Temperaturdrift verursachte Frequenzverstimmungen erfahren.

Vor diesem Hintergrund besteht die Aufgabe der Erfindung in der Angabe eines Oszillators und eines Verfahrens zum Steuern eines Oszillators, bei denen die genannten Nachteile verringert sind.

Diese Aufgabe wird bei einem Oszillator der eingangs genannten Art durch eine erste Steuerspannungsquelle gelöst, die erste Steuerspannungen mit wenigstens drei stufenförmig unterschiedlichen Werten an die erste Schwingkreis-Kapazität anlegt.

Entsprechend wird diese Aufgabe bei einem Verfahren der eingangs genannten Art dadurch gelöst, dass die Schwingkreis-Kapazität durch eine erste Steuerspannungsquelle eingestellt wird, die erste Steuerspannungen mit wenigstens drei stufenförmig unterschiedlichen Werten an die erste Schwingkreis-Kapazität anlegt.

Durch diese Merkmale wird eine schaltbare Steuerung ein und derselben Schwingkreis-Kapazität, beispielsweise der Kapazität einer Kapazitätsdiode oder eines zusammengeschalteten Paars von Kapazitätsdioden bereitgestellt. Diese Lösung besitzt den Vorteil eines geringeren Platzbedarfs, weil viele Kapazitäten mit kleinen (gestuften) Werten - durch die Forderung nach Einhaltung von Isolationsabständen - mehr Platz benötigen als eine große Kapazität. Die Summe der Werte der kleinen Kapazitäten muss stets genauso groß sein wie der Wert der großen Kapazität, da sonst der Schwingkreis auf einer falschen Frequenz oszillieren würde. Die Erfindung erlaubt daher eine Schwingkreis-Steuerung mit einer verringerten Zahl von Kapazitätsdioden, was den Platzbedarf im Rahmen einer integrierten Schaltung vorteilhaft verkleinert. Außerdem ergibt sich mit steigender Zahl der stufenförmig unterschiedlichen Kapazitätswerte die Möglichkeit, die Zahl der stufenförmig variierbaren Kapazitätswerte so zu steigern, so dass sich im Ergebnis jeweils flacher verlaufende Frequenz-Steuerspannungskennlinien für einen überlagernden Eingriff einer zweiten Steuerspannung ergeben, was das Phasenrauschen verringert. Dies wird weiter unten noch detaillierter ausgeführt.

Mit Blick auf Ausgestaltungen des Oszillators ist bevorzugt, dass die erste Steuerspannungsquelle n Stromquellen aufweist, die einzeln schaltbar mit einem Lastwiderstand verbunden sind, über dem die erste Steuerspannung abfällt. Dabei umfasst der Begriff des Widerstandes nicht nur Ohm'sche Widerstände, sondern jedes Bauteil oder jedes Netzwerk von Bauteilen, über dem bei einem Stromfluss eine Spannung abfällt. Der Widerstand kann insbesondere wenigstens ein Sperrschichtbauteil, zum Beispiel eine Diode aufweisen. Die Verwendung von Dioden als Widerstandsbauteil bewirkt bereits einen geeigneten Temperaturgang oder kann zumindest in Verbindung mit temperaturabhängigen Stromquellen den gewünschten Temperaturgang bewirken. Die Zahl n der Stromquellen kann jede ganzzahlige positive Zahl 1, 2, 3..... sein. Für n = 1 können die wenigstens drei verschiedenen Steuerspannungswerte durch ein Einschalten unterschiedlicher Widerstände in den Stromkreis der Stromquelle erzeugt werden.

Durch die schaltbare Verbindung mit wenigstens einem Lastwiderstand lassen sich durch verschiedene Kombinationen von vergleichsweise wenigen Stromquellen vergleichsweise viele stufenförmig verschiedene Werte einer Steuerspannung generieren. Außerdem bieten Stromquellen den Vorteil, dass ihnen ein Temperaturverhalten eingeprägt werden kann, mit dem das Temperaturverhalten der Kapazität kompensiert werden kann.

Eine weitere bevorzugte Ausgestaltung zeichnet sich durch eine erste Steuerung aus, die entweder keine der n Stromquellen, genau eine der n Stromquellen, eine Kombination aller n Stromquellen oder eine Unterkombination der n Stromquellen mit dem Lastwiderstand verbindet.

Diese Ausgestaltung realisiert den im vorstehenden Absatz genannten Vorteil einer Erzeugung einer großen Zahl von Steuerspannungen aus einer vergleichsweise kleinen Zahl von Stromquellen.

Bevorzugt ist auch, dass wenigstens eine der n Stromquellen einen von ihrer Temperatur abhängigen Strom ausgibt.

Diese Ausgestaltung realisiert den weiter vom genannten Vorteil einer Kompensation des Temperaturverhaltens der steuerbaren Kapazität. Es versteht sich, dass bei der Wahl des Temperaturverhaltens der Stromquellen sämtliche Schaltungskomponenten so berücksichtigt werden, dass die Frequenz des Oszillators über der Temperatur insgesamt stabil bleibt.

Eine weitere bevorzugte Ausgestaltung zeichnet sich durch genau n = zwei Stromquellen aus.

Es hat sich gezeigt, dass in vielen Fällen, beispielsweise bei Anwendungen in der mobilen Kommunikationstechnik, diese geringe Zahl von Stromquellen zu einer ausreichenden Steuermöglichkeit für die Kapazitätsvariation führt. Je nachdem, ob keine, eine oder beide Stromquellen mit dem Lastwiderstand verbunden werden, ergeben sich drei Steuerspannungswerte. Diese Zahl kann auf vier erhöht werden, wenn beide Stromquellen unterschiedliche Ströme erzeugen. Dies gilt mit entsprechender Änderung der Zahlenwerte analog für n Stromquellen.

Daher ist auch bevorzugt, dass wenigstens zwei der n Stromquellen Ströme unterschiedlicher Stärke ausgeben.

Alternativ ist bevorzugt, dass nur eine Stromquelle in Verbindung mit einem Netzwerk von Widerständen zur Bereitstellung der wenigstens drei Steuerspannungswerte genutzt wird. Dafür wird die Stromquelle und/oder das Netzwerk von Widerständen bevorzugt so ausgewählt, dass sie den Temperaturgang des gesamten Oszillators kompensieren.

Eine weitere bevorzugte Ausgestaltung zeichnet sich durch wenigstens eine zweite Schwingkreiskapazität und eine zweite Steuerung aus, wobei die zweite Steuerung eine analoge, stetig veränderbare Steuerspannung ausgibt, die den Wert der zweiten Schwingkreiskapazität bestimmt.

Bei Schwingkreisen, die durch eine weitere analoge Steuerspannung (zweite Steuerspannung) einstellbar sind, überlagern sich die Einflüsse der ersten und der zweiten Steuerspannung derart, dass mit der ersten Steuerspannung eine bestimmte Kennlinie aus einer Kennlinienschar von Frequenz-Steuerspannungsabhängigkeiten ausgewählt wird. Dadurch ergibt sich die Möglichkeit, die eigentlich gewünschte Frequenzeinstellung durch die analoge, zweite Steuerspannung vorzunehmen und die erste Steuerspannung gewissermaßen zur Verschiebung dieser Kennlinie zu verwenden.

Bevorzugt ist auch, dass die erste und/oder die zweite Schwingkreiskapazität jeweils durch zwei gegeneinander geschaltete Kapazitätsdioden realisiert sind.

Durch diese symmetrische Anordnung, bei der die analoge Steuerspannung zwischen beiden Dioden eingespeist wird, erfolgt eine Gleichstrom-Entkopplung der Steuerspannung vom Schwingkreis, was eine unerwünschte Wechselwirkung zwischen Schwingkreis-Wechselspannung und der analogen Steuerspannung verhindert oder zumindest verringert.

Ferner ist bevorzugt, dass die zweite Steuerung eine Ladungspumpe einer Phasenregelschleife ist.

Diese Ausgestaltung integriert die Erfindung in das Konzept von Phasenregelschleifen, sö dass die weiter oben genannten Vorteile dort ihre Wirkung entfalten.

Mit Blick auf Ausgestaltungen des Verfahrens ist bevorzugt, dass die erste Steuerspannung durch eine Verbindung von entweder keiner von n Stromquellen, genau einer von n Stromquellen, einer Kombination aller n Stromquellen oder einer Unterkombination von (n - m) der n Stromquellen mit einem Lastwiderstand erzeugt wird, wobei die Kombination jeweils durch Steuersignale einer ersten Steuerung erfolgt.

Bevorzugt ist auch, dass eine zweite Schwingkreiskapazität durch eine zweite Steuerung gesteuert wird, wobei die zweite Steuerung eine analoge, stetig veränderbare Steuerspannung ausgibt, die den Wert der zweiten Schwingkreiskapazität bestimmt.

Diese Ausgestaltung von Verfahrensaspekten der Erfindung liefern zu den entsprechenden Vorrichtungsausgestaltungen korrespondierende Vorteile.

Weitere Vorteile ergeben sich aus der Beschreibung und den beigefügten Figuren.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Zeichnungen

Ausführungsbeispiele der Erfindung sind in den Zeichnungen dargestellt und werden in der nachfolgenden Beschreibung näher erläutert. Es zeigen, jeweils schematisch:
- Fig. 1: ein Schaltbild der eingangs genannten, per se bekannten Schaltung;
- Fig. 2: einen Bereich der gewünschten Frequenzen einer solchen Schaltung und die unerwünschte Verbreiterung dieses Bereichs durch Temperatur- und Fertigungseinflüsse;
- Fig. 3: verschiedene Frequenzbereiche, die sich bei der Schaltung nach Fig. 1 durch Variation der Zahl geschalteter Kapazitäten ergeben;
- Fig. 4: ein Ausführungsbeispiel eines erfindungsgemäßen Oszillators:
- Fig. 5: Frequenzbereiche wie in Fig. 3, wie sie sich in schmalerer Form bei einem erfindungsgemäßen Oszillator aus Fig. 4 ergeben; und
- Fig. 6: qualitativ eine Wirkung der Erfindung, die sich aus einer größeren Zahl stufenförmig änderbarer Kapazitätswerte ergibt und die Kennlinien für den Eingriff der zweiten Steuerspannung flacher verlaufen lässt, was das unerwünschte Phasenrauschen verringert.

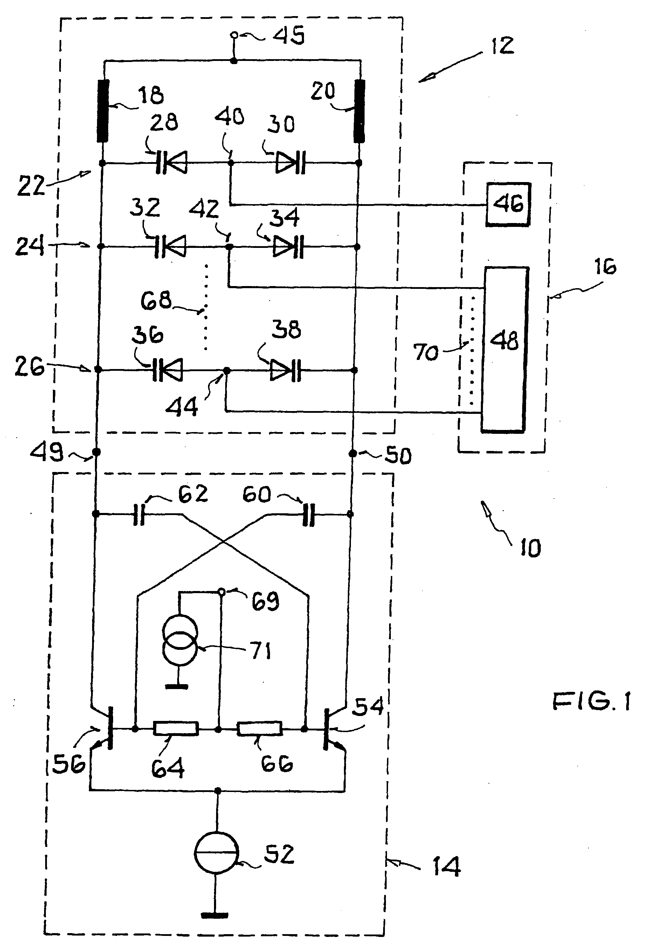

Figur 1 zeigt die Gesamtansicht des an sich bekannten Oszillators 10 mit einem Schwingkreis 12, einer Entdämpfungsschaltung 14 und einer Steuerung 16. Der Schwingkreis 12 weist eine Parallelschaltung aus Induktivitäten 18, 20 und ersten Kapazitäten 24 und 26 sowie einer zweiten Kapazität 22 auf. Jede der ersten und zweiten Kapazitäten 22, 24, 26 ist als Paar von gegeneinander geschalteten Kapazitätsdioden oder Varaktordioden 28, 30; 32, 34 und 36, 38 aufgebaut. Jedes Paar 28, 30; 32, 34; 36, 38 der Kapazitätsdioden weist einen Anschlussknoten 40, 42, 44 auf, über den die Steuerung 16 eine variable Gleichspannung zur Einstellung der spannungsabhängigen Kapazität jedes Paars von Kapazitäten 28, 30; 32, 34; 36, 38 einspeist.

Eine erste Teilsteuerung 48 der Steuerung 16 liefert binäre Spannungswerte an die Knoten 42, 44, so dass die zugehörigen ersten Kapazitäten 24, 26 binär zwischen jeweils zwei möglichen Kapazitätswerten umgeschaltet werden. Eine zweite Teilsteuerung 46 der Steuerung 16 liefert eine analoge, stetig veränderliche Gleichspannung an den Knoten 40, so dass der Wert der zugehörigen zweiten Kapazität 22 stetig veränderlich ist. Der Schwingkreis 12 mit seinen Induktivitäten 18, 20 und Kapazitäten 22, 24, 26 liegt zwischen einem Versorgungsspannungsanschluss 45 und der Entdämpfungsschaltung 14, die über Knoten 49, 50 mit dem Schwingkreis 12 verbunden ist. An den Knoten 49, 50 kann auch das Ausgangssignal des Oszillators 10 abgenommen werden.

Die Entdämpfungsschaltung 14 besteht aus einer Gleichstromquelle 52, einem Paar von Transistoren 54, 56, einem Paar von Kapazitäten 60, 62 und einem Paar von Widerständen 64, 66. Die Kollektor-Emitterstrecke des Transistors 54 liegt zwischen dem Knoten 50 und der Gleichstromquelle 52. Analog liegt die Kollektor-Emitterstrecke des Transistors 56 zwischen dem Knoten 49 und der Gleichstromquelle 52. Über die Kapazität 60 wird die Basis des Transistors 56 wechselstrommäßig an den Knoten 50 angekoppelt. Analog koppelt die Kapazität 62 die Basis des Transistors 54 wechselstrommäßig mit dem Knoten 49. Die Basen der Transistoren 54 und 56 sind über Widerstände 64 und 66 mit dem Knoten 69 verbunden, der für die Arbeitspunkteinstellung der Transistoren 54 und 56 von einer Spannungsquelle 71 versorgt wird.

Die Entdämpfungsschaltung 14 stellt damit eine Wechselstromquelle mit einer kapazitiven Kreuz-Kopplung der Kollektoren und Basen eines differentiellen Paares von Transistoren 54, 56 dar, die dem Schwingkreis 12 über die Knoten 49, 50 phasenrichtig Energie zuführt und damit Dämpfungsverluste des Schwingkreises 12 ersetzt.

Die punktierten Linien 68, 70 zeigen an, dass zwischen den Kapazitäten 24 und 26 auch weitere (n -2) Kapazitäten eingeschaltet sein können, so dass sich n Kapazitäten ergeben, die von der ersten Teilsteuerung 48 geschaltet werden.

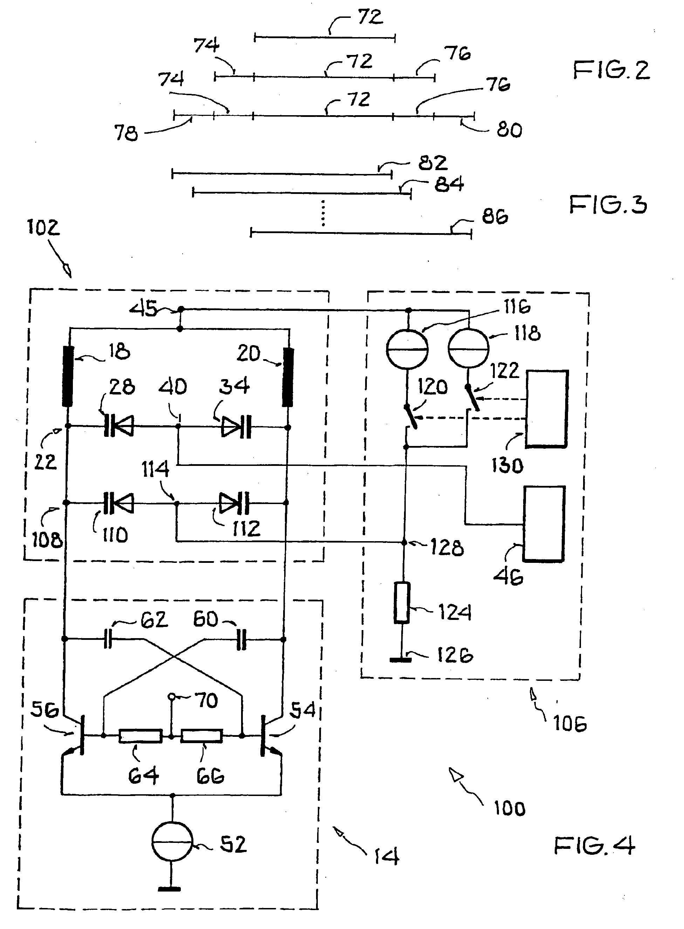

Figur 2 zeigt verschiedene Frequenzbereiche, wie sie von einem Oszillator 10 nach Figur 1 bereit gestellt werden. Dabei entspricht der mittlere Frequenzbereich 72 dem gewünschten Frequenzspektrum, bspw. einer Bandbreite von 0,1 Gigahertz für eine Bluetooth-Anwendung zwischen 2,4 und 2,5 Gigahertz. In Abhängigkeit von der Temperatur des Oszillators 10 wird diese gewünschte Bandbreite 72 durch Temperaturdrift-Erscheinungen verbreitert, was in der Figur 2 durch seitlich verbreiternde Bereiche 74, 76 angedeutet wird. Eine zusätzliche Verbreiterung tritt durch Schwankungen der elektrischen Eigenschaften der verwendeten Bauteile des Oszillators 10 ein, die durch den Fertigungsprozess bedingt sind. In der Figur 2 ist eine solche, Bauelemente-bedingte Verbreiterung durch seitliche Bereiche 78, 80 dargestellt.

Der per se bekannte Oszillator 10 nach der Figur 1 wird so betrieben, dass die erste Steuerung 48 digital entweder keine der ersten Kapazitäten 24, 26, eine der ersten Kapazitäten 24, 26 oder beide erste Kapazitäten 24, 26 ansteuert. Dies gilt entsprechend für den Fall, dass zwischen den Kapazitäten 24, 26 weitere (n - 2) Kapazitäten liegen. In Abhängigkeit von dem durch die erste Steuerung 48 definierten Schaltzustand der ersten Kapazitäten 24, 26 ergibt sich einer der in Figur 3 dargestellten überlappenden Frequenzbereiche 82, 84 und 86. Dabei sind die ersten Kapazitäten 24, 26 und die von der ersten Steuerung 48 ausgegebenen Steuerspannungen für die Knoten 42, 44 so dimensioniert, dass die einander überlappenden Frequenzbereiche 82, 84 und 86 nach Figur 3 das gesamte Frequenzspektrum 78, 74, 72, 76, 80 aus Figur 2 abdecken. Die erste Steuerung 48 wählt damit gewissermaßen einen Teilbereich 82, 84, 86 des gesamten abzudeckenden Spektrums 78, 74, 72, 76, 80 aus.

Innerhalb eines der vorgewählten Bereiche 82, 84, 86 übernimmt dann die zweite Steuerung 46 durch Ausgabe eines analogen, kontinuierlich veränderlichen Gleichspannungssignals an den Knoten 40 der zweiten Kapazität 22 die Aufgabe, die jeweils gewünschte Frequenz genau einzustellen.

Wie bereits eingangs beschrieben, besitzt ein Oszillator 10, wie er in Figur 1 dargestellt ist, den Nachteil, dass vergleichsweise viele platzraubende erste Kapazitäten 24, 26 erforderlich sind, um das Frequenzspektrum 78, 74, 72, 76, 80 mit Teilbereichen 82, 84, 86 abzudecken. Beschränkt man sich auf wenige erste Kapazitäten 24, 26, so resultieren daraus vergleichsweise breite Bereiche 82, 84, 86, was aufgrund des in Summe größeren Abstimmbereiches zu einer größeren Abstimmsteilheit und somit zu einem unerwünscht großen Phasenrauschen führt. Dies wird weiter unten im Zusammenhang mit der Figur 6 noch näher erläutert.

Figur 4 zeigt ein Ausführungsbeispiel eines erfindungsgemäßen Oszillators 100, der die genannten Nachteile vermeidet. Der Oszillator 100 nach Figur 4 unterscheidet sich vom per se bekannten Oszillator 10 nach Figur 1 durch einen geänderten Schwingkreis 102, der den Schwingkreis 12 aus Figur 1 ersetzt, sowie durch eine geänderte Steuerung 106, die die Steuerung 16 nach Figur 1 ersetzt. Nicht geänderte Komponenten sind in der Figur 1 und der Figur 4 mit gleichen Bezugszeichen erläutert und werden daher im Zusammenhang mit der Figur 4 nicht nochmals erläutert. Der geänderte Schwingkreis 102 zeichnet sich dadurch aus, dass die n-Kapazitäten 24 bis 26 nach Figur 1 durch eine einzige Kapazität 108 aus paarweise gegeneinander geschalteten Kapazitätsdioden 110, 112 ersetzt worden sind. Der Wert dieser Kapazität wird über eine stufenförmig umsteuerbare Gleichspannung variiert, die von der geänderten Steuerung 106 an einen Knoten 114 angelegt wird.

Zur Erzeugung der stufenförmig änderbaren Gleichspannung für den Knoten 114 weist die Steuerung 106 n-Gleichstromquellen (n = 1, 2, 3, ...) auf, von denen zwei Gleichstromquellen 116, 118 stellvertretend für alle n-Gleichstromquellen in der Figur 4 dargestellt sind. Über einzeln steuerbare Schalter 120, 122 kann jede der n-Stromquellen 116, 118 mit einem Lastwiderstand 124 verbunden werden, so dass sich bei geschlossenem Schalter 120 und/oder 122 eine Reihenschaltung aus Stromquelle 116 und/oder 118 und Lastwiderstand 124 ergibt, die zwischen dem Versorgungsspannungsanschluss 45 und einem Massepotential 126 liegt. Je nach Schaltzustand der Schalter 120, 122 stellt sich daher an einem Knoten 128, der leitend mit dem Knoten 114 der steuerbaren Kapazität 108 verbunden ist, eine stufenförmig veränderliche Gleichspannung ein. Alternativ zur Schaltung mehrerer Stromquellen 116, 118 auf einen Lastwiderstand 124 kann eine Variation der Steuerspannung auch dadurch erzielt werden, dass eine einzige Stromquelle, bspw. die Stromquelle 116, auf ein Netzwerk von Widerständen 124 geschaltet wird, wobei der Widerstand des Netzwerks 124 durch Steuerung von Schaltern 120, 122 variiert wird. Von der Topologie her könnte die eine Stromquelle zum Beispiel am Ort des Einzelwiderstands 124 angeordnet sein, wobei an den Orten der Stromquellen 116, 118 Widerstände angeordnet werden. Je nachdem, ob einer, keiner oder beide Widerstände einer solchen Anordnung in den Stromfluss geschaltet werden, ergeben sich auch bei einer solchen Ausgestaltung drei Steuerspannungswerte am Knoten 114.

Die Schalter 120, 122 werden von einer ersten Teilsteuerung 130 betätigt. Im Gegensatz zum Oszillator 10 nach Figur 1 wird die Kapazität des Schwingkreises 102 nach Figur 4 nicht durch binäres Zu- oder Wegschalten von Kapazitäten 24, 26, sondern durch Variation der Steuerspannung für eine einzige Kapazität 108 verändert. Die Variation der Steuerspannung findet beim Gegenstand der Figur 4 durch Zu- oder Wegschalten der Ströme von Gleichstromquellen 116, 118 statt, die wesentlich weniger Platz benötigen als die Kapazitäten 24, 26 aus der Figur 1.

Die Gleichstromquellen 116, 118 stellen daher zusammen mit den Schaltern 120, 122 und ggf dem Lastwiderstand 124 und der ersten Steuerung 130 ein Ausführungsbeispiel einer ersten Steuerspannungsquelle (116, 118, 120, 122) dar, die erste Steuerspannungen mit wenigstens drei stufenförmig unterschiedlichen Werten an die erste Schwingkreis-Kapazität (108) anlegt.

Die Gleichstromquellen 116, 118 können jeweils gleiche Stromstärken oder verschiedene Stromstärken ausgeben. Außerdem werden sie vorteilhafterweise so realisiert, dass ihr Temperaturverhalten das Temperaturverhalten der Kapazität 108 kompensiert. Bei der Wahl des Temperaturverhaltens der Stromquellen werden sämtliche Schaltungskomponenten so berücksichtigt, dass die Frequenz des Oszillators über der Temperatur stabil bleibt.

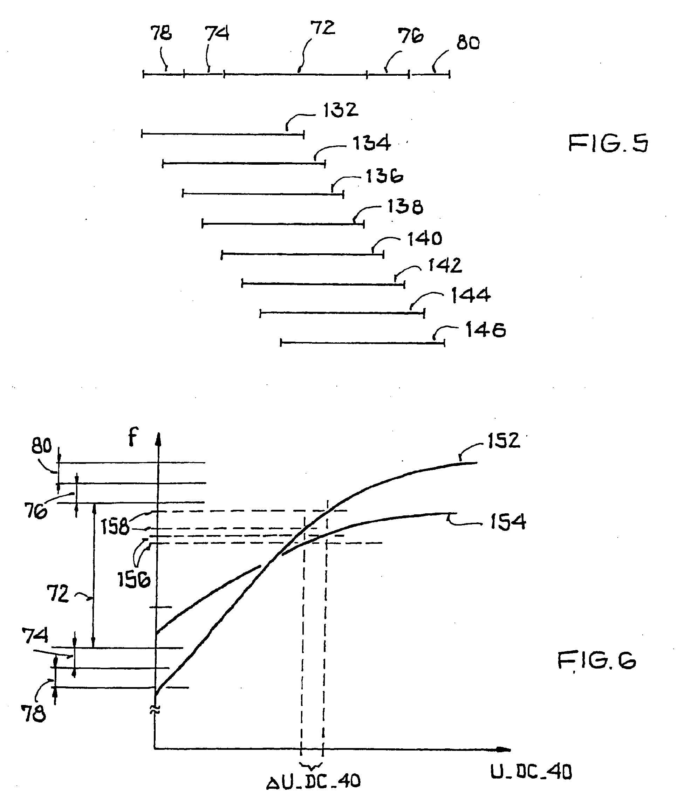

Das Ersetzen der n-Kapazitäten 24, 26 aus Figur 1 durch eine einzige Kapazität 108 in Verbindung mit n Stromquellen 116, 118 aus Figur 4 hat über den Vorteil des geringeren Platzbedarfes hinaus den Vorteil, dass die Veränderung der kapazitätsbestimmenden Gleichspannung wesentlich feinstufiger erfolgen kann. Dies ist in der Figur 5 durch eine feinstufigere Unterteilung des gesamten Frequenzbereiches 78, 74, 72, 76, 80 durch acht Teilfrequenzbereiche 132, 134, 136, 138, 140, 142, 144 und 146 dargestellt, von denen jeder einen Schaltzustand der n-Schalter 120, 122 aus Figur 4 repräsentiert. Jeder einzelne der Bereiche 132, ...., 146, kann daher wesentlich schmaler ausfallen als jeder der Bereiche 82, 84, 86 aus der Figur 3. Die Breite der Bereiche folgt unmittelbar aus den schaltungstechnischen Anforderungen. Die Wahl des Gesamtbereiches zu 78+74+72+76+80 ist ausreichend, aber durch diesen großen Bereich ist die Abstimmsteilheit und damit das Phasenrauschen groß. Werden die fertigungsbedingten Streuungen berücksichtigt, so genügt es den Bereich 74+72+76 zu erfassen (+/- etwa die Hälfte der Schrittweite von 82 zu 84, ...). Geringstes Phasenrauschen wird erzielt wenn der Abstimmbereich mit Temperaturkompensation lediglich den Bereich 72 umfasst (+/- etwa die Hälfte der Schrittweite von 132 zu 134, ...).

Acht Teilbereiche lassen sich zum Beispiel durch drei Stromquellen und drei Schalter realisieren, wenn die Ströme der drei Stromquellen ungleich sind. Wenn in diesem Fall eine 1 einen geschlossenen Schalter und eine 0 einen offenen Schalter repräsentiert, ergeben sich die folgenden 8 möglichen Schaltzustände, die zu 8 verschiedenen Summenströmen und damit 8 verschiedenen Spannungen an den Knoten 114, 128 führen. Die erste Steuerung 130 gibt entsprechende Datenworte aus, die solche Schaltzustände festlegen. Die folgende Tabelle zeigt die möglichen Schaltzustände für diesem Fall.

| Schaltstellung | Schalter 1 | Schalter 2 | Schalter 3 |
|---|---|---|---|
| A | 0 | 0 | 0 |
| B | 1 | 0 | 0 |
| C | 0 | 1 | 0 |
| D | 1 | 1 | 0 |
| E | 0 | 0 | 1 |
| F | 1 | 0 | 1 |
| G | 0 | 1 | 1 |
| H | 1 | 1 | 1 |

Es versteht sich, dass bei der Anordnung der Stromquellen 116, 118 und dem Widerstand 124 auch eine Umpolung möglich ist, also der Widerstand 124 gegen den Knoten 45 und die Stromquellen 116, 118 gegen Masse 126 geschaltet sein können. Der Effekt der Verkleinerung der Bandbreiten der Frequenzbereiche 132, ..., 146 führt zu dem weiteren vorteilhaften Ergebnis, dass die Kennlinie für den analogen Steuereingriff der zweiten Steuerung 46 auf den Knoten 40 des Schwingkreises 102 flacher verläuft. Im Ergebnis wird dadurch das Phasenrauschen reduziert, wie aus Figur 6 ersichtlich ist. Auf der Abszisse der Figur 6 ist die Steuerspannung U_DC_40 aufgetragen, die von der zweiten Steuerung 46 an die Knoten 40 der Schwingkreise 12. 102 angelegt wird. Auf der Ordinate der Figur 6 sind die Frequenzbereiche 78, 74, 72, 76, 80 aus den Figuren 2 und 5 dargestellt.

Die Kennlinie 152 gehört zu dem Schwingkreis 12 aus Figur 1 und beschreibt das Ausmaß der Frequenzvariation des Schwingkreises 12 bei Änderungen ΔU_DC_40 der Steuerspannung U_DC_40 innerhalb eines der Frequenzbereiche 82, 84, 86 aus der Figur 3. Dagegen stellt die Kennlinie 154 die Abhängigkeit zwischen einer Änderung der Frequenz f und einer Änderung ΔU_DC_40 der Steuerspannung U_DC_40 im Fall des Oszillators 100 aus Figur 4 innerhalb eines der Frequenzbereiche 132, ..., 146 dar.

Da die Frequenzbereiche 132, ..., 146 schmaler sind als die Frequenzbereiche 82, 84, 86, verläuft die Kennlinie 154 des Oszillators 100 aus Figur 4 flacher als die entsprechende Kennlinie 152 des Oszillators 10 aus Figur 1. Jeweils gleiche Schwankungsbreiten ΔU_DC_40 der Steuerspannung U_DC_40 haben daher bei der flacheren Kennlinie 154 kleinere Frequenzänderungen 156 zur Folge, während die gleiche Schwankungsbreite ΔU_DC_40 der Steuerspannung U_DC_40 im Fall der steileren Kennlinie 152 zu größeren Frequenzschwankungen 158 führt. Da die Frequenzänderungen 156, 158 ein Maß für das Phasenrauschen darstellen, zeigt die Figur 6, dass der Gegenstand der Figur 4 zu einem vorteilhaft kleineren Phasenrauschen führt als der per se bekannte Gegenstand der Figur 1.

## Patentansprüche

1. Oszillator (100) mit einem Schwingkreis (102) aus wenigstens einer Schwingkreis-Induktivität (18, 20) und einer ersten Schwingkreis-Kapazität (108), wobei der Wert der ersten Schwingkreis-Kapazität (108) durch erste Steuerspannungen zwischen verschiedenen Stufen umsteuerbar ist, **gekennzeichnet durch** eine erste Steuerspannungsquelle (116, 118, 120, 122), die erste Steuerspannungen mit wenigstens drei stufenförmig unterschiedlichen Werten an die erste Schwingkreis-Kapazität (108) anlegt.

2. Oszillator (100) nach Anspruch 1, **dadurch gekennzeichnet, dass** die erste Steuerspannungsquelle (116, 118, 120, 122) n Stromquellen (116, 118) aufweist, die einzeln schaltbar mit einem Lastwiderstand (124) verbunden sind, über dem die erste Steuerspannung abfällt.

3. Oszillator (100) nach Anspruch 2, **gekennzeichnet durch** ein Sperrschichtbauteil als Lastwiderstand (124).

4. Oszillator (100) nach Anspruch 2 oder 3, **gekennzeichnet durch** eine erste Steuerung (130), die entweder keine der n Stromquellen (116, 118), genau eine der Stromquellen (116, 118), eine Kombination aller n Stromquellen (116, 118) oder eine Unterkombination der n Stromquellen (116, 118) mit dem Lastwiderstand (124) verbindet.

5. Oszillator (100) nach wenigstens einem der Ansprüche 2 bis 4, **dadurch gekennzeichnet, dass** wenigstens eine der n Stromquellen (116, 118) einen von ihrer Temperatur abhängigen Strom ausgibt.

6. Oszillator (100) nach wenigstens einem der Ansprüche 2 bis 5, **gekennzeichnet durch** genau n = zwei Stromquellen (116, 118).

7. Oszillator (100) nach wenigstens einem der Ansprüche 2 bis 6, **dadurch gekennzeichnet, dass** wenigstens zwei der n Stromquellen (116, 118) Ströme unterschiedlicher Stärke ausgeben.

8. Oszillator (100) nach Anspruch 2 oder 3, **dadurch gekennzeichnet, dass** nur eine Stromquelle (116) in Verbindung mit einem Netzwerk von Widerständen (124) zur Bereitstellung der wenigstens drei Steuerspannungswerte genutzt wird.

9. Oszillator (100) nach Anspruch 8, **dadurch gekennzeichnet, dass** die Stromquelle (116) und/oder das Netzwerk von Widerständen (124) den Temperaturgang des gesamten Oszillators (100) kompensieren.

10. Oszillator (100) nach wenigstens einem der vorhergehenden Ansprüche, **gekennzeichnet durch** wenigstens eine zweite Schwingkreiskapazität (22) und eine zweite Steuerung (46), wobei die zweite Steuerung (46) eine analoge, stetig veränderbare Steuerspannung (U_DC_40) ausgibt, die den Wert der zweiten Schwingkreiskapazität (22) bestimmt.

11. Oszillator (100) nach wenigstens einem der Ansprüche 1 bis 10, **dadurch gekennzeichnet, dass** die erste und/oder die zweite Schwingkreiskapazität (108; 22) jeweils durch zwei gegeneinander geschaltete Kapazitätsdioden (110, 112; 28, 34) realisiert sind.

12. Oszillator (100) nach Anspruch 10, **dadurch gekennzeichnet, dass** die zweite Steuerung (46) eine Ladungspumpe einer Phasenregelschleife aufweist.

13. Verfahren zur Einstellung der Frequenz eines Oszillators (100) mit einem Schwingkreis (102) aus wenigstens einer Schwingkreis-Induktivität (18, 20) und einer ersten Schwingkreis-Kapazität (108), wobei der Wert der ersten Schwingkreis-Kapazität (108) durch erste Steuerspannungen zwischen verschiedenen Stufen umgesteuert wird, **dadurch gekennzeichnet, dass** die erste Schwingkreis-Kapazität (108) durch eine erste Steuerspannungsquelle (116, 118, 120, 122) eingestellt wird, die erste Steuerspannungen mit wenigstens drei stufenförmig unterschiedlichen Werten an die erste Schwingkreis-Kapazität (108) anlegt.

14. Verfahren nach Anspruch 10, **dadurch gekennzeichnet, dass** die erste Steuerspannung durch eine Verbindung von entweder keiner von n Stromquellen (116, 118), genau einer von n Stromquellen (116, 118), einer Kombination von n Stromquellen (116, 118) oder einer Unterkombination von n Stromquellen (116 118) mit einem Lastwiderstand (124) erzeugt wird, wobei die Verbindung jeweils durch eine erste Steuerung (130) erfolgt.

15. Verfahren nach Anspruch 10 oder 11, **dadurch gekennzeichnet, dass** eine zweite Schwingkreiskapazität (22) durch eine zweite Steuerung (46) gesteuert wird, wobei die zweite Steuerung (46) eine analoge, stetig veränderbare Steuerspannung (U_DC_40) ausgibt, die den Wert der zweiten Schwingkreiskapazität (22) bestimmt.
